# FASCICULE DE BREVET EUROPEEN

(11) **EP 0 676 837 B1**
(45) Date de publication et mention de la délivrance du brevet: **05.07.2000**
(21) Numéro de dépôt: 95400734.0
(22) Date de dépôt: 03.04.1995
(51) Int. Cl.: H01S 5/02, H01L 21/265

(54) **Procédé de décalage de longueur d'onde dans une structure semi-conductrice à puits quantique**
Verfahren zur Verschiebung der Wellenlänge eines Halbleiterquantumwells
Method for shifting the wavelength of a semiconductor quantum well

(30) Priorité: 06.04.1994 FR 9404017
(43) Date de publication de la demande: 11.10.1995
(73) Titulaire: ALCATEL, 75008 Paris (FR)
(72) Inventeur: Emery, Jean-Yves, F-75010 Paris (FR); Goldstein, Léon, F-92370 Chaville (FR)
(74) Mandataire: Fournier, Michel Robert Marie

(56) Documents cités:
- EP-A- 0 429 979
- PROCEEDINGS OF THE SIXTH INTERNATIONAL CONFERENCE ON INDIUM PHOSPHIDE AND RELATED MATERIALS, MARCH 27-31 1994 FESS PARKERS RED LION RESORT SANTA BARBARA CALIFORNIA USA, PAPER WC4, pages 355-358, J-Y EMERY ET AL 'Intefrated laser waveguide structures using selective area intermixing'
- APPLIED PHYSICS LETTERS., vol. 58, no. 13, 1 Avril 1994 NEW YORK US, pages 1363-1365, S. O'BRIEN ET AL 'Monolithic integration of an AlGaAs laser and intracavity electroabsorption modulator using selective partial interdiffusion'
- SEMICONDUCTOR SCIENCE AND TECHNOLOGY, vol. 8, no. 6, Juin 1993 LONDON GB, pages 1156-1165, R.E. MALLARD ET AL 'The control and evaluation of blue shift in GaInAs/GaInAsP multiple quantum well structures for integrated lasers and stark effect modulators'
- APPLIED PHYSICS LETTERS., vol. 55, no. 7, 14 Août 1989 NEW YORK US, pages 672-674, H. RIBOT ET AL 'Disordering of GaAs/AlGaAs multiple quantum well structures by thermal annealing for monolithic integration of laser and phase modulator'
- IEEE PHOTONICS TECHNOLOGY LETTERS, vol. 5, no. 11, 1261 NEW YORK US, pages 1261-1263, 1263 'Low Threshold lasers fabricated by the alignment free impurity induced disordering'

## Description

La présente invention concerne de manière générale un procédé de décalage de longueur d'onde dans une structure semiconductrice à puits quantique. Elle s'applique notamment à l'intégration d'un laser et d'un modulateur d'amplitude sous la forme de deux segments successifs d'une même structure semiconductrice du type III-V, ces deux segments constituant un segment laser et un segment modulateur et différant l'un de l'autre par les longueurs d'onde caractéristique de leurs couches guidantes. Le composant optique qui résulte d'une telle intégration trouve application dans les systèmes de télécommunication à fibres optiques.

Plusieurs procédés sont connus pour réaliser une telle intégration. Un premier tel procédé est dit "de couplage bout à bout" (en anglais "butt coupling") et décrit dans l'article suivant:
B. Garrett and E.J. Thrush - J. Crys. Growth - 97 (1989) 273.

Il présente l'inconvénient de comporter un grand nombre d'étapes.

Cet inconvénient est évité dans un deuxième procédé connu décrit dans un article de : T. Kats, T. Sanaki, K. Komatsu and J. Mits, Electron - Letters. 28 (1992) 153.

Ce deuxième procédé comporte une croissance épitaxiale sélective dans une zone limitée par un masque diélectrique bordant le segment laser. Une différence apparaît alors entre les longueurs d'onde caractéristiques des deux segments. Elle résulte de différences d'épaisseur et de composition provoquées par la diffusion des espèces gazeuses à partir des zones recouverte par le masque vers les zones ouvertes. Actuellement, seule l'épitaxie en phase vapeur aux organométalliques à basse pression (LP-OMVPE) permet de mettre ce procédé en oeuvre. Dans ce procédé les mises aux points technologiques sont longues.

Un troisième procédé connu peut être appelé "interdiffusion induite localisée". Il permet d'éviter les inconvénients ci-dessus et est décrit dans un article de : J.Y. Emery, L. Golstein, C. Stark, P. Pagnod-Rossiaux, J.L. Peyre, F. Gabarit, C. Labourie, F.H. Julien and C. Francis. Proceedings of the fifth International Conference on InP. and Related Materials, Paris 1993, P1 (postdeadline paper).

Il sera précisé ci-après.

Il présente les inconvénients d'être difficilement transposable à une fabrication industrielle et de donner des résultats difficilement reproductibles.
L'invention est définie par la revendication 1. Divers modes de réalisation sont définis par les revendications dépendantes.
La présente invention a notamment pour but d'éviter d'une manière simple les inconvénients ci-dessus. Elle utilise un procédé de décalage de longueur d'onde dans une structure semiconductrice à puits quantique. Ce procédé inclue l'interdiffusion des éléments constitutifs des puits et des barrières d'une structure quantique. Cette structure quantique est interne à une structure semiconductrice du type III-V. L'interdiffusion est induite à chaud à partir de la face supérieure de cette structure. Ce procédé se caractérise par le fait que cette interdiffusion est induite par une couche d'un matériau inducteur maintenu dans un état condensé au contact de ladite face de la structure semiconductrice.

A l'aide des figures schématiques ci-jointes, on va décrire plus particulièrement, à titre d'exemple non limitatif, comment la présente invention peut être mise en oeuvre. Lorsqu'un même élément est représenté sur plusieurs figures il y est désigné par le même signe de référence.

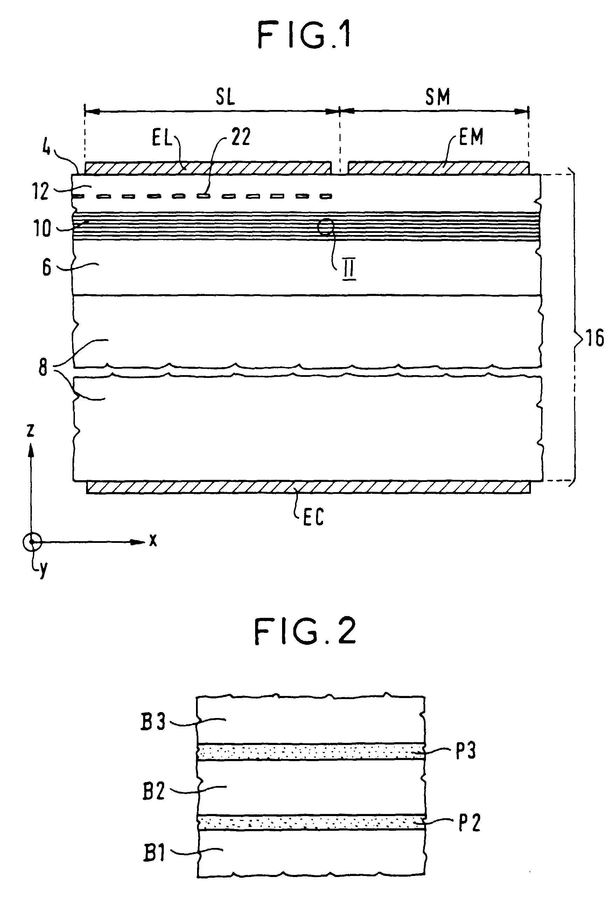

La figure 1 représente une vue en coupe longitudinale d'un composant optique incluant une structure à décalage de longueur d'onde formée à l'aide du procédé de cette invention.

La figure 2 représente un détail II de la figure 1.

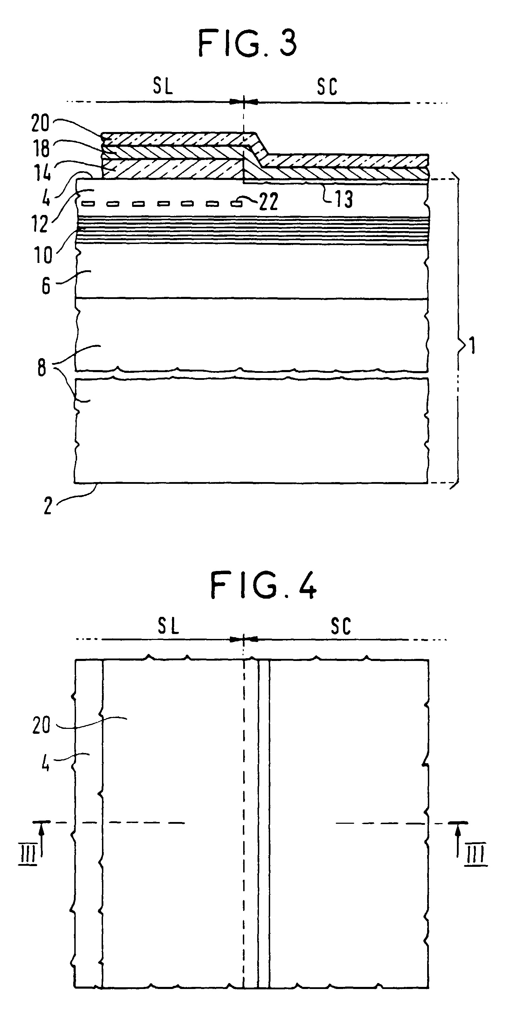

La figure 3 représente une vue partielle d'une structure de départ lors d'une étape de décalage devant la transformer en la structure à décalage de longueur d'onde de la figure 1. Cette vue est en coupe longitudinale selon une ligne III-III de la figure 4.

La figure 4 représente une vue partielle de dessus de la stucture de la figure 3.

On va tout d'abord décrire diverses étapes qui sont communes au procédé selon l'invention et au troisième procédé connu précédemment mentionné.

Dans une première telle étape commune on réalise une structure de départ monocristalline constituée de matériaux semiconducteurs du type III-V comportant de l'indium et du gallium comme éléments III et du phosphore et de l'arsenic comme éléments V. Le rapport des teneurs d'un tel matériau en phosphore et en arsenic sera désigné ci-après comme le rapport phosphore sur arsenic de ce matériau. Cette structure définit des directions longitudinale X, transversale Y et verticale Z. Elle comporte les couches suivantes qui se succèdent selon cette direction verticale d'une face inférieure 2 à une face supérieure 4 de cette structure:
- Une couche de confinement inférieure 6. Cette couche est constituée d'InP et épaisse de 200 nm au moins. Elle a un premier type de conductivité, par exemple le type n. Elle est formée sur un substrat 8 du même type de conductivité épaisse de 300 µm.
- Une structure quantique 10. Cette structure est constituée par une succession verticale alternative de puits quantiques tels que P2 et P3 et de barrières telles que B1, B2 et B3. Le nombre de ces puits est par exemple six. Des surfaces de frontières SF apparaissent entre ces puits et ces barrières. Le rapport phosphore sur arsenic du matériau des puits est différent du rapport phosphore sur arsenic du matériau des barrières. Cette structure quantique a une longueur d'onde caractéristique, par exemple 1,5 µm, dépendant de ces rapports ainsi que des épaisseurs des couches et des teneurs en éléments III. Dans cette première étape cette longueur d'onde est constante selon la direction longitudinale.
- Enfin une couche de confinement supérieure 12 d'un deuxième type de conductivité p opposé au premier. Cette couche est constituée d'InP et a une épaisseur de 300 nm au moins. Cette structure est telle que le passage d'un courant de polarisation d'un sens direct entre ces deux couches de confinement assure l'injection de porteurs de charges des deux types opposés dans la structure quantique 10. Cette injection permet l'amplification sélective d'ondes lumineuses ayant la longueur d'onde caractéristique de cette structure quantique.

Ce procédé comporte ensuite les étapes suivantes:
- On définit dans la longueur de la structure de départ deux segments séparés constituant un segment à longueur d'onde décalée SM et un segment à longueur d'onde conservée SL.
- On forme une couche de protection 14 recouvrant la face supérieure 4 de la structure de départ dans le segment à longueur d'onde conservée SL tout en laissant cette face exposée dans le segment à longueur d'onde décalée SM. Cette couche est par exemple diélectrique et épaisse de 300 nm.
- Dans une étape de décalage on expose cette face supérieure à l'action d'un matériau inducteur de diffusion, ceci à une température d'interdiffusion. La concentration de ce matériau et cette température sont suffisantes pour provoquer une modification affectant une partie superficielle 13 de la couche de confinement supérieure 12 et pour induire ainsi dans la structure quantique 10, à travers la couche de confinement supérieure, une interdiffusion des éléments V. Cette interdiffusion fait diffuser le phosphore et l'arsenic à travers les surfaces de frontières SF de la structure quantique 10 et provoque ainsi un décalage localisé souhaité de la longueur d'onde caractéristique de cette couche. Cette modification, cette interdiffusion et ce décalage sont au moins limités par la couche de protection 14 dans le segment à longueur d'onde conservée SL.

Le décalage de longueur d'onde ainsi réalisé est un décalage vers le bleu. Il est de plusieurs dizaines de nanomètres. Les longueurs d'onde conservées et décalées valent par exemple 1490 nm et 1420 nm.
- Enfin on attaque la face supérieure 4 de la structure de départ ainsi modifiée pour éliminer la couche de protection 14 dans le segment à longueur d'onde conservée SL et la partie superficielle modifiée 13 de la couche de confinement supérieure 12 dans le segment à longueur d'onde décalée SM. On obtient ainsi une structure à longueur d'onde localement décalée 16 susceptible de conduire des dits courants de polarisation dans les segments à longueurs d'onde conservée et décalée et présentant des longueurs d'onde caractéristiques différentes dans ces deux segments.

Dans le troisième procédé connu mentionné ci-dessus, l'étape de décalage comporte la mise de la structure dans une ampoule scellée contenant du phosphore en tant que matériau inducteur. Cette ampoule est ensuite chauffée à une température d'interdiffusion pour exposer la face supérieure de la structure à une pression de vapeur importante de ce matériau. La température d'interdiffusion est comprise entre 600° et 700°C.

Selon la présente invention l'étape de décalage comporte elle même les étapes suivantes:
- On dépose une couche dudit matériau inducteur 18 sur la face supérieure 4 de la structure de départ 1. Ce matériau est avantageusement choisi dans les colonnes III et V de la classification périodique des éléments. Il est constitué de préférence par l'indium.
- On dépose sur cette couche de matériau inducteur une couche d'encapsulation 20 étanche et résistante à la température d'interdiffusion. Cette couche est par exemple diélectrique et épaisse de 50 nm.
- Enfin on chauffe la structure de départ à la température d'interdiffusion qui reste comprise entre 600 et 700°C.

La couche d'encapsulation évite l'évaporation, l'écoulement et/ou l'oxydation du matériau inducteur à cette température. On évite ainsi les inconvénients de la mise de la structure sous ampoule scellée. La structure protégée par la couche d'encapsulation peut être recuite plusieurs fois pour obtenir avec précision un décalage de longueur d'onde de la valeur souhaitée. Ce décalage est en effet apparu comme variant linéairement en fonction de la durée totale des opérations de recuit effectuées à la température d'interdiffusion. Par ailleurs l'indium peut être facilement déposé sous la forme d'une couche mince présentant une épaisseur régulière. Cette épaisseur est typiquement comprise entre 3 et 300 nm, de préférence entre 10 et 50 nm environ.

La gamme de températures d'interdiffusion indiquée ci-dessus a été choisie suffisamment basse pour éviter à la fois une interdiffusion des éléments III à travers les surfaces frontières SF dans la structure quantique 10 et une diffusion de matériaux de dopage des couches de confinement inférieure 6 et supérieure 12 vers cette structure quantique.

Les couches de protection 14 et d'encapsulation 20 sont de préférence constituées de matériaux diélectriques usuels tels que la silice Si02 et le nitrure de silicium Si3N4.

Dans le cadre de la réalisation de composants pour un système de télécommunication à fibres optiques on dépose des électrodes EL, EM et EC sur les faces inférieure 2 et supérieure 4 de la structure à longueur d'onde localement décalée 16. Ce sont, sur la face supérieure 4, une électrode de laser EL dans le segment SL et une électrode de modulateur EM dans le segment SM, et sur la face inférieure 2 une électrode commune EC.

Par ailleurs une cavité résonante a été formée dans cette structure, par exemple par un réseau de Bragg 22. Ce dernier est situé dans la couche de confinement supérieur 12 de la structure de départ.

On réalise ainsi un composant optique semiconducteur incluant sous forme intégrée un émetteur et un modulateur. L'émetteur est un laser présentant un gain positif dans le segment à longueur d'onde conservée. Le modulateur module la lumière de cet émetteur dans le segment à longueur d'onde décalée. Typiquement la cavité résonante 22 est formée dans le segment à longueur d'onde conservée SL, et le modulateur module l'amplitude de la lumière de l'émetteur.

## Revendications

1. Procédé de décalage de longueur d'onde dans une structure semiconductrice à puits quantique, ce procédé incluant une interdiffusion d'éléments entre au moins un puits (P2) et une barrière (B2) d'une structure quantique (10) incluse entre deux couches de confinement appartenant à une structure semiconductrice (1) du type III-V, cette interdiffusion étant induite à chaud par un matériau inducteur agissant à partir d'une face (4) de cette structure semiconductrice dans les conditions de température évitant une diffusion de matériaux de dopage des dites couches de confinement (6, 12) vers cette structure quantique,
le matériau inducteur présentant la forme d'une couche (18) de matière condensée maintenue au contact de ladite face (4) de la structure semiconductrice (1).

2. Procédé selon la revendication 1, caractérisé par le fait que ledit matériau inducteur est choisi parmi les éléments III et V inclus dans les colonnes III et V de la classification périodique des éléments, respectivement.

3. Procédé selon la revendication 2, caractérisé par le fait que ledit matériau inducteur est l'indium.

4. Procédé selon la revendication 3, caractérisé par le fait que ladite couche de matériau inducteur a une épaisseur comprise entre 3 et 300 nm et de préférence entre 10 et 50 nm.

5. Procédé selon la revendication 1, caractérisé par le fait que ladite interdiffusion est réalisée à une température d'interdiffusion suffisamment haute pour permettre la diffusion d'éléments V et suffisamment basse pour éviter celle des éléments III.

6. Procédé selon la revendication 5, caractérisé par le fait que ladite température d'interdiffusion est comprise entre 600°C et 700°C.

7. Procédé selon la revendication 1, ce procédé comportant d'abord la réalisation d'une structure de départ monocristalline constituée de matériaux semiconducteurs du type III-V comportant de l'indium et du gallium comme éléments III et du phosphore et de l'arsenic comme éléments V, le rapport des teneurs d'un tel matériau en phosphore et en arsenic constituant un rapport phosphore sur arsenic de ce matériau, cette structure présentant des directions longitudinale (X), transversale (Y) et verticale (Z) et comportant des couches se succèdant selon cette direction verticale dans l'ordre suivant entre une face inférieure (2) et une face supérieure (4) de cette structure:
- une couche de confinement inférieure (6) d'un premier type de conductivité,
- une structure quantique (10) constituée par une succession verticale alternative de puits quantiques (P2, P3) et de barrières (B1, B2, B3) présentant des surfaces de frontières (SF) entre ces puits et ces barrières, le rapport phosphore sur arsenic du matériau des puits étant différent du rapport phosphore sur arsenic du matériau des barrières, cette structure quantique ayant une longueur d'onde caractéristique dépendant de ces rapports, cette longueur d'onde étant d'abord constante selon la direction longitudinale,
- et une couche de confinement supérieure (12) d'un deuxième type de conductivité opposé au premier de manière que le passage d'un courant de polarisation d'un sens direct entre ces deux couches de confinement assure l'injection de porteurs de charges des deux types opposés dans la structure quantique (10) et que cette injection permette l'amplification sélective d'ondes lumineuses ayant ladite longueur d'onde caractéristique de cette structure quantique, ce procédé comportant ensuite les étapes suivantes:
- on définit dans la longueur de la structure de départ deux segments séparés constituant un segment à longueur d'onde décalée (SM) et un segment à longueur d'onde conservée (SL),
- on forme une couche de protection (14) recouvrant la face supérieure (4) de la structure de départ dans le segment à longueur d'onde conservée (SL) tout en laissant cette face exposée dans le segment à longueur d'onde décalée (SM),
- dans une étape de décalage on expose cette face supérieure à l'action d'un matériau inducteur de diffusion, ceci à une température d'interdiffusion, la concentration de ce matériau et cette température étant suffisantes pour provoquer une modification affectant une partie superficielle (13) de la couche de confinement supérieure (12) et pour induire ainsi dans la structure quantique (10), à travers la couche de confinement supérieure, une interdiffusion des éléments V, cette interdiffusion faisant diffuser le phosphore et l'arsenic à travers les surfaces de frontières (SF) de la structure quantique (10) et provoquant ainsi un décalage localisé souhaité de la longueur d'onde caractéristique de cette couche, cette modification, cette interdiffusion et ce décalage étant au moins limités par la couche de protection (14) dans le segment à longueur d'onde conservée (SL),
- et on attaque la face supérieure (4) de la structure de départ modifiée pour éliminer la couche de protection (14) dans le segment à longueur d'onde conservée (SL) et la partie superficielle modifiée (13) de la couche de confinement supérieure (12) dans le segment à longueur d'onde décalée (SM), grâce à quoi on obtient une structure à longueur d'onde localement décalée (16) susceptible de conduire desdits courants de polarisation dans lesdits segments à longueurs d'onde conservée et décalée et présentant des longueurs d'onde caractéristiques différentes dans ces deux segments,
ledit procédé étant caractérisé par le fait que ladite étape de décalage comporte elle même les étapes suivantes:
- on dépose une couche dudit matériau inducteur (18) sur la face supérieure (4) de la structure de départ (1),
- on dépose sur cette couche de matériau inducteur une couche d'encapsulation (20) étanche et résistante à la température d'interdiffusion,
- et on chauffe la structure de départ à la température d'interdiffusion.

8. Procédé selon la revendication 7, caractérisé par le fait que lesdites couches de protection (14) et d'encapsulation (20) sont constituées de matériaux diélectriques tels que la silice Si02 et le nitrure de silicium Si3N4.

9. Procédé selon la revendication 7, caractérisé par le fait qu'on dépose des électrodes (EL, EM, EC) sur les faces inférieure (2) et supérieure (4) de la structure à longueur d'onde localement décalée (16), une cavité résonante (22) étant formée dans cette structure de manière à réaliser un composant optique semiconducteur incluant sous forme intégrée un émetteur et un modulateur, cet émetteur étant un émetteur laser présentant un gain positif dans le segment à longueur d'onde conservée, ce modulateur modulant la lumière de cet émetteur dans le segment à longueur d'onde décalée.

10. Procédé selon la revendication 9, caractérisé par le fait que ladite cavité résonante (22) est formée dans le segment à longueur d'onde conservée (SL), ledit modulateur modulant l'amplitude de la lumière de l'émetteur.

## Patentansprüche

1. Verfahren zum Verschieben der Wellenlänge in einer Quantum-Well-Halbleiterstruktur, wobei das Verfahren eine Interdiffusion von Elementen zwischen wenigstens einem Well (P2) und einer Barriere (B2) einer Quantenstruktur (10) beinhaltet, die zwischen zwei Confinement-Schichten eingeschlossen ist, die zu einer Halbleiterstruktur (1) vom Typ III-V gehören, wobei diese Interdiffusion in heißem Zustand durch ein Induktormaterial induziert wird, das von einer Seite (4) dieser Halbleiterstruktur unter Temperaturbedingungen einwirkt, die eine Diffusion von Dotiermaterialien der Confinement-Schichten (6, 12) zu der Quantenstruktur verhindern, wobei das Induktormaterial die Form einer Schicht (18) aus kondensiertem Material aufweist, die in Kontakt mit der Seite (4) der Halbleiterstruktur (1) gehalten wird.

2. Verfahren nach Anspruch 1, dadurch gekennzeichnet, dass das Induktormaterial unter den III- und V-Elementen der Spalten III und V des Periodensystems der Elemente ausgewählt wird.

3. Verfahren nach Anspruch 2, dadurch gekennzeichnet, dass das Induktormaterial Indium ist.

4. Verfahren nach Anspruch 3, dadurch gekennzeichnet, dass die Schicht des Induktormaterials eine Dicke zwischen 3 und 300 nm und vorzugsweise zwischen 10 und 50 nm hat.

5. Verfahren nach Anspruch 1, dadurch gekennzeichnet, dass die Interdiffusion bei einer Interdiffusionstemperatur durchgeführt wird, die hoch genug ist, um die Diffusion von V-Elementen zu ermöglichen, und die niedrig genug ist, um die der III-Elemente zu vermeiden.

6. Verfahren nach Anspruch 5, dadurch gekennzeichnet, dass die Interdiffusionstemperatur zwischen 600°C und 700°C beträgt.

7. Verfahren nach Anspruch 1, wobei das Verfahren zunächst die Realisierung einer monokristallinen Ausgangsstruktur umfasst, die aus Halbleitermaterialien vom Typ III-V gebildet ist, die Indium und Gallium als III-Elemente und Phosphor und Arsen als V-Elemente umfasst, wobei das Verhältnis der Gehalte eines solchen Materials an Phosphor und an Arsen ein Phosphor-Arsen-Verhältnis des Materials darstellt und diese Struktur longitudinale (x), transversale (Y) und vertikale (Z) Richtungen aufweist und Schichten umfasst, die in dieser vertikalen Richtung in folgender Reihenfolge von einer Unterseite (2) zu einer Oberseite (4) dieser Struktur aufeinanderfolgen:
- eine untere Confinement-Schicht (6) mit einem ersten Leitfähigkeitstyp,
- eine Quantenstruktur (10), gebildet durch eine vertikale alternierende Folge von Quantum Wells (P2, P3) und Barrieren (B1, B2, B3), die Grenzflächen (SP) zwischen diesen Wells und diesen Barrieren aufweist, wobei das Phosphor-Arsen-Verhältnis des Materials der Wells vom Phosphor-Arsen-Verhältnis des Materials der Barrieren verschieden ist und diese Quantenstruktur eine von diesen Verhältnissen abhängige charakteristische Wellenlänge hat, wobei die Wellenlänge zunächst in longitudinaler Richtung konstant ist,
- und eine obere Confinement-Schicht (12) mit einem zweiten, dem ersten entgegengesetzten Leitfähigkeitstyp, so dass der Durchgang eines Polarisierungsstromes in einer direkten Richtung zwischen diesen zwei Confinement-Schichten die Einspeisung von Ladungsträgern beider entgegengesetzter Typen in diese Quantenstruktur (10) gewährleistet und diese Einspeisung die selektive Verstärkung von Lichtwellen mit der charakteristischen Wellenlänge dieser Quantenstruktur ermöglicht, wobei das Verfahren anschließend die folgenden Schritte umfasst:
- Definieren von zwei getrennten Segmenten in der Länge der Ausgangsstruktur, die ein Segment mit verschobener Wellenlänge (SM) und ein Segment mit beibehaltener Wellenlänge (SL) bilden,
- Bilden einer Schutzschicht (14), die die Oberseite (4) der Ausgangs struktur in dem Segment mit beibehaltener Wellenlänge (SL) bedeckt und dabei diese Seite in dem Segment mit verschobener Wellenlänge (SM) freilässt,
- in einem Verschiebungsschritt Aussetzen der Oberseite der Wirkung eines Diffusionsinduktormaterials, und zwar bei einer Interdiffusionstemperatur, wobei die Konzentration dieses Materials und diese Temperatur ausreichend sind, um eine Veränderung hervorzurufen, die einen oberflächlichen Bereich (13) der oberen Confinement-Schicht (12) betrifft und um so in der Quantenstruktur (10) durch die obere Confinement-Schicht hindurch eine Interdiffusion der V-Elemente zu bewirken, wobei diese Interdiffusion den Phosphor und das Arsen durch die Grenzflächen (SF) der Quantenstruktur (10) hindurchdiffundieren lässt und so eine gewünschte lokalisierte Verschiebung der charakteristischen Wellenlänge dieser Schicht bewirkt, wobei diese Veränderung, diese Interdiffusion und diese Verschiebung wenigstens durch die Schutzschicht in dem Segment mit beibehaltener Wellenlänge (SL) begrenzt sind,
- Angreifen der Oberseite (4) der veränderten Ausgangsstruktur, um die Schutzschicht (14) in dem Segment mit beibehaltener Wellenlänge (SL) und den oberflächlich veränderten Bereich (13) der oberen Confinement-Schicht (12) in dem Segment mit verschobener Wellenlänge (SM) zu beseitigen, wodurch eine Struktur mit lokal verschobener Wellenlänge (16) erhalten wird, die in der Lage ist, die Polarisierungsströme in den Segmenten mit beibehaltener Wellenlänge und mit verschobener Wellenlänge zu führen, die in den zwei Segmenten verschiedene charakteristische Wellenlängen aufweisen,
dadurch gekennzeichnet, dass der Verschiebungsschritt seinerseits die folgenden Schritte umfasst:
- Abscheiden einer Schicht des Induktormaterials (18) auf der Oberseite (4) der Ausgangsstruktur (1),
- Abscheiden einer dichten und gegen die Interdiffusionstemperatur beständigen Kapselungsschicht (20) auf dieser Schicht Induktormaterial,
- und Erhitzen der Ausgangsstruktur auf die Interdiffusionstemperatur.

8. Verfahren nach Anspruch 7, dadurch gekennzeichnet, dass die Schutz- (14) und Kapselungsschichten (20) durch dielektrische Materialien wie etwa Quarz SiO₂ und Si,N, gebildet sind.

9. Verfahren nach Anspruch 7, dadurch gekennzeichnet, dass Elektroden (EL, EM, EC) auf der Unterseite (2) und Oberseite (4) der Struktur mit lokal verschobener Wellenlänge (16) abgeschieden werden, wobei eine Resonatorkavität (22) in dieser Struktur gebildet wird, um ein optisches Halbleiterbauelement zu realisieren, das in integrierter Form einen Sender und einen Modulator beinhaltet, wobei dieser Sender ein Lasersender ist, der eine positive Verstärkung in dem Segment mit beibehaltener Wellenlänge aufweist und dieser Modulator das Licht dieses Senders in dem Segment mit verschobener Wellenlänge moduliert.

10. Verfahren nach Anspruch 9, dadurch gekennzeichnet, dass die Resonatorkavität (22) in dem Segment mit beibehaltener Wellenlänge (SL) gebildet wird und der Modulator die Amplitude des Lichts des Senders moduliert.

## Claims

1. A method of shifting a wavelength in a semiconductor structure having quantum wells, in which method elements are inter-diffused between at least one well (P2) and a barrier (B2) of a quantum structure (10) included between two confinement layers belonging to a III-V type semiconductor structure (1), the inter-diffusion being hot induced by an inducing material acting from a face (4) of the semiconductor structure in temperature conditions that prevent doping materials from being diffused from said confinement layers (6, 12) to the quantum structure, the inducing material being in the form of a layer (18) of condensed substance maintained in contact with said face (4) of the semiconductor structure (1).

2. A method according to claim 1, characterized by the fact that said inducing material is chosen from III and V elements respectively included in columns III and V of the periodic table of elements.

3. A method according to claim 2, characterized by the fact that said inducing material is indium.

4. A method according to claim 3, characterized by the fact that said layer of inducing material has a thickness lying in the range 3 nm to 300 nm, and preferably lying in the range 10 nm to 50 nm.

5. A method according to claim 1, characterized by the fact that said inter-diffusion is performed at an inter-diffusion temperature that is high enough to enable V elements to be diffused, and that is low enough to prevent III elements from being diffused.

6. A method according to claim 5, characterized by the fact that said inter-diffusion temperature lies in the range 600°C to 700°C.

7. A method according to claim 1, in which method firstly an initial monocrystal structure is made of III-V type semiconductor materials including indium and gallium as III elements and phosphorus and arsenic as V elements, the ratio of the phosphorus content to the arsenic content of such a material constituting a phosphorus-to-arsenic ratio of the material, the structure having a longitudinal direction (X), a transverse direction (Y), and a vertical direction (Z), and including layers that succeed one another in the vertical direction in the following order between a bottom face (2) and a top face (4) of the structure:
a bottom confinement layer (6) of a first conductivity type;
a quantum structure (10) constituted by a vertical alternating succession of quantum wells (P2, P3) and of barriers (B1, B2, B3) having border surfaces (SF) between the wells and the barriers, the phosphorus-to-arsenic ratio of the material of the wells being different from the phosphorus-to-arsenic ratio of the material of the barriers, the quantum structure having a characteristic wavelength that is dependent on said ratios, the wavelength being initially constant in the longitudinal direction; and
a top confinement layer (12) of a second conductivity type that is opposite to the first conductivity type so that a bias current being passed in a forward direction between the two confinement layers causes charge carriers of the two opposite types to be injected into the quantum structure (10), and so that the injection enables light waves having said characteristic wavelength of the quantum structure to be selectively amplified, the method then including the following steps:
two separate segments are defined along the length of the initial structure, which segments constitute a shifted-wavelength segment (SM) and a conserved-wavelength segment (SL);
a protection layer (14) is formed covering the top face (4) of the initial structure in the conserved-wavelength segment (SL) while leaving that face exposed in the shifted-wavelength segment (SM);
in a shifting step, the top face is exposed under the action of a diffusion-inducing material at an inter-diffusion temperature, the concentration of the material and the temperature being sufficient to cause a modification affecting a surface portion (13) of the top confinement layer (12), and to induce inter-diffusion of the V elements in the quantum structure (10) via the top confinement layer, the inter-diffusion causing the phosphorus and the arsenic to diffuse via the border surfaces (SF) of the quantum structure (10), thereby causing a desired localized shift in the characteristic wavelength of the layer, the modification, the inter-diffusion, and the shift being at least limited by the protective layer (14) in the conserved-wavelength segment (SL); and
the top face (4) of the modified initial structure is etched so as to remove the protective layer (14) in the conserved-wavelength segment (SL), and the modified surface portion (13) of the top confinement layer (12) in the shifted-wavelength segment (SM), whereby a structure (16) is obtained which has a locally-shifted wavelength, which is capable of conducting said bias currents through said conserved-wavelength segment and through said shifted-wavelength segment, and which has different characteristic wavelengths in the two segments;
said method being characterized by the fact that said shifting step includes the following steps:
a layer of said inducing material (18) is deposited on the top face (4) of the initial structure (1);
a leak-proof encapsulation layer (20) that withstands the inter-diffusion temperature is deposited on said layer of inducing material; and
the initial structure is heated to the inter-diffusion temperature.

8. A method according to claim 7, characterized by the fact that said protective layer (14) and said encapsulation layer (20) are made of dielectric materials such as silica SiO₂ and silicon nitride Si₃N₄.

9. A method according to claim 7, characterized by the fact that electrodes (EL, EM, EC) are deposited on the bottom face (2) and on the top face (4) of the structure (16) having the locally-shifted wavelength, a resonant cavity (22) being formed in that structure so as to make a semiconductor optical component including an emitter and a modulator in integrated form, the emitter being a laser emitter having positive gain in the conserved-wavelength segment, the modulator modulating the light from the emitter in the shifted-wavelength segment.

10. A method according to claim 9, characterized by the fact that said resonant cavity (22) is formed in the conserved-wavelength segment (SL), said modulator modulating the amplitude of the light from the emitter.
